(19) **Europäisches Patentamt European Patent Office Office européen des brevets**

(11) **EP 4 697 595 A1**

(12) **EUROPEAN PATENT APPLICATION**

(43) Date of publication:
**18.02.2026 Bulletin 2026/08**

(21) Application number: **25194024.3**

(22) Date of filing: **05.08.2025**

(51) International Patent Classification (IPC):
**H03F 1/30** $^{(2006.01)}$ **H03F 3/183** $^{(2006.01)}$
**H03F 3/217** $^{(2006.01)}$

(52) Cooperative Patent Classification (CPC):
**H03F 3/2175; H03F 1/30; H03F 3/183;**
H03F 2200/03

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **12.08.2024 US 202418800572**

(71) Applicant: **NXP B.V.**
**5656 AG Eindhoven (NL)**

(72) Inventors:
• **Kamran, Muhammad**
**5656AG Eindhoven (NL)**
• **Kup, Bernardus Martinus Johannes**
**5656AG Eindhoven (NL)**
• **van Loosdrecht, Freddie Alexandra**
**5656AG Eindhoven (NL)**
• **Neuteboom, Harry**
**5656AG Eindhoven (NL)**

(74) Representative: **Miles, John Richard**
**NXP Semiconductors**
**Intellectual Property Group**
**The Cattle Barn, Upper Ashfield Farm**
**Hoe Lane**
**Romsey, Hampshire SO51 9NJ (GB)**

(54) **SWITCHING AMPLIFIER WITH POWER SUPPLY RIPPLE CORRECTION**

(57)    An amplifier includes an amplifier chain and a digital correction loop coupled to the amplifier chain. The digital correction loop includes an analog-to-digital (ADC) converter, an averaging filter, and a digital divider. The digital correction loop is configured to generate a correction factor based on ripple or noise in a supply voltage. The amplifier chain is configured to apply the correction factor to an input signal.

**FIG. 1**

EP 4 697 595 A1

## Description

BACKGROUND

Class D amplifiers, also known as switching amplifiers, are utilized in various applications ranging from portable audio devices, such as smartphones and tablets, to high-power audio systems in home theaters, automotive audio systems, and professional audio equipment. Their compact size, high efficiency, and ability to provide significant power output with relatively low heat dissipation make them well-suited for these applications. Unlike traditional linear amplifiers, which amplify audio signals using continuously variable signals, Class D amplifiers convert audio signals into a series of high-frequency pulse-width modulated (PWM) signals or pulse density modulation (PDM) signals. These PWM and PDM signals drive output transistors, which switch between fully-on and fully-off states, thereby reducing power losses associated with the transistor's conduction states.

SUMMARY

Aspects of the disclosure are defined in the accompanying claims. In a first aspect, there is provided an amplifier, comprising: an amplifier chain; and a digital correction loop configured to compensate for fluctuations in a supply voltage, the digital correction loop comprising: an analog-to-digital (ADC) converter; an averaging filter; and a digital divider.

In some embodiments, an output of the ADC is coupled to an input of the averaging filter and an output of the averaging filter is coupled to an input of the digital divider.

In some embodiments, an output of the amplifier chain is coupled to an input of one or more audio output devices.

In some embodiments, the amplifier chain includes an upsampler, a gain stage, a noise shaper, a modulator, a power amplifier controller, and an output driver.

In some embodiments, an output of the upsampler is coupled to an input of the gain stage; an output of the gain stage is coupled to an input of the noise shaper; an output of the noise shaper is coupled to an input of the modulator; an output of the modulator is coupled to an input of the power amplifier controller; and an output of the power amplifier controller is coupled to an input of the output driver.

In some embodiments, an output of the output driver is coupled to an input of one or more audio output devices.

In some embodiments, the ADC is configured to: sample a supply voltage; and generate a digital signal representing the supply voltage.

In some embodiments, the averaging filter is configured to: calculate an average of a series of consecutive digital samples of a digital signal representing a supply voltage; and generate an average value signal of the supply voltage based on the calculated average.

In some embodiments, the digital divider is configured to: divide an average value signal of a supply voltage by a digital signal representing the supply voltage; generate a correction factor for ripple or noise on the supply voltage based on the average value signal being divided by the digital signal; and output the correction factor to the amplifier chain.

In some embodiments, the amplifier chain is configured to: apply the correction factor to a signal to generate a corrected signal; and output the corrected signal to a component coupled to the amplifier.

In some embodiments, the amplifier chain comprises a gain stage and wherein the amplifier chain is configured to apply the correction factor by: receiving, by the gain stage, the correction factor from the digital divider; increasing, by the gain stage, a gain of the signal based on the correction factor to generate the corrected signal; and outputting the corrected signal to a subsequent component of the amplifier chain.

In a second aspect, there is provided a method at an amplifier, comprising: monitoring, by a digital correction loop, a supply voltage; generating, by the digital correction loop, a correction factor based on the supply voltage; applying, by an amplifier chain, the correction factor to an input signal to generate a corrected input signal; and outputting the corrected input signal to a component coupled to the amplifier.

In some embodiments, generating the correction factor comprises: sampling, by the digital correction loop, the supply voltage; and generating, by the digital correction loop, a digital signal representing the supply voltage.

In some embodiments, generating the correction factor comprises: calculating an average of a series of consecutive digital samples of a digital signal representing the supply voltage; and generating an average value signal of the supply voltage based on the calculated average.

In some embodiments, generating the correction factor comprises: dividing an average value signal of a supply voltage by a digital signal representing the supply voltage; generating a correction factor for ripple or noise on the supply voltage based on the average value signal being divided by the digital signal; and outputting the correction factor to the amplifier chain.

In some embodiments, applying the correction factor to the input signal comprises: receiving, by the amplifier chain, the correction factor from the digital correction loop; and increasing, by the amplifier chain, a gain of the input signal based on the correction factor to generate the corrected input signal.

In a third aspect, there is provided an amplifier, comprising: an upsampler configured to configured generate an upsampled signal; a gain stage coupled to the upsampler and configured to generate an amplified signal; a noise shaper coupled to the gain stage and configured to generate a noise-shaped signal; a modulator coupled to the noise shaper and configured to generate a modulated signal; a power amplifier controller coupled to the modulator and configured to generate a switching signal; an output driver coupled to the power amplifier controller and configured to generate an amplified output signal; an analog-to-digital (ADC) converter coupled to a supply voltage and configured to generate a digital signal representing a signal from the supply voltage; an averaging filter coupled to the ADC and configured to generate an average value signal of the supply voltage; and a digital divider coupled to the averaging filter and the gain stage and configured to generate a correction factor to compensate for fluctuations in the supply voltage.

In some embodiments, wherein ADC is configured to: sample the supply voltage; and generate the digital signal representing the supply voltage based on the sampled supply voltage, wherein the averaging filter is configured to: calculate an average of a series of consecutive digital samples of the digital signal; and generate an average value signal of the supply voltage based on the calculated average.

In some embodiments, the digital divider is configured to: divide the average value signal by the digital signal; generate the correction factor for ripple or noise on the supply voltage based on the average value signal being divided by the digital signal; and output the correction factor to the gain stage.

In some embodiments, the upsampler is configured to generate the upsampled signal based on a received input signal; the gain stage is configured to apply the correction factor to increase a gain of the upsampled signal based on the correction factor to generate the amplified signal, which is a corrected signal; the noise shaper is configured to generate the noise-shaped signal based on the corrected signal; the modulator is configured to generate the modulated signal based on the noise-shaped signal; the power amplifier controller is configured to generate the switching signal based on the modulated signal; and the output driver is configured to amplify the switching signal to generate the amplified output signal.

## BRIEF DESCRIPTION OF THE DRAWINGS

The present disclosure may be better understood, and its numerous features and advantages made apparent to those skilled in the art by referencing the accompanying drawings. The use of the same reference symbols in different drawings indicates similar or identical items.

FIG. 1 is a schematic of an amplifier implementing a digital correction loop in accordance with some implementations.

FIG. 2 is a flow diagram illustrating an example method of compensating for ripple on a power supply line coupled to the amplifier of FIG. 1 in accordance with some implementations.

## DETAILED DESCRIPTION

Class D amplifiers, or switching amplifiers, are well-known for their high efficiency, which is achieved by switching output transistors between fully on and fully off states. This method of operation mitigates power dissipation, making Class D amplifiers well-suited for battery-powered applications. However, one of the inherent characteristics of Class D amplifiers is their 0 decibel (dB) power supply rejection (PSR). This means that any ripple or noise on the power supply line is directly transferred to the output, which can be audible through the speaker.

To mitigate this issue, conventional Class D amplifiers often implement an analog feedback loop across the amplifier to enhance PSR and reduce distortion. While effective, this approach is both power-intensive and occupies significant chip area, presenting a challenge in applications with stringent power and size constraints.

Total harmonic distortion (THD) is another important consideration in audio amplification. THD measures the distortion of the audio signal caused by harmonics introduced during amplification. Lower THD indicates higher audio fidelity, which is beneficial for maintaining the quality of the output sound. In the conventional setup, the gain from the noise shaper output to the speaker, referred to as $V_{SPDR}$, determines how supply ripple manifests at the speaker output. Any ripple on the power supply directly impacts the speaker output, making it audible. An analog loop across the output driver can mitigate this issue by improving both PSR and THD, but at the cost of increased power consumption and larger area requirements. This challenge is particularly pronounced in applications that use batteries with relatively large output impedance, such as Zinc-Air (Zn-Air) batteries. While the THD requirements in some applications can be relaxed, managing the audible ripple caused by the power supply, as well as addressing power consumption, PSR, and chip area constraints, remains an issue that needs to be efficiently resolved without compromising the compact and power-efficient nature of these devices.

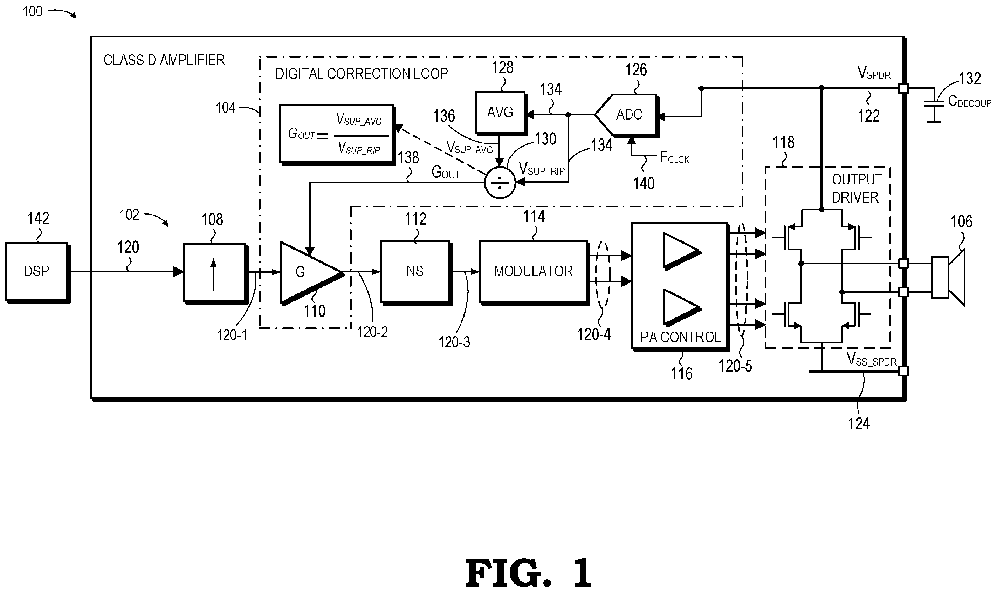

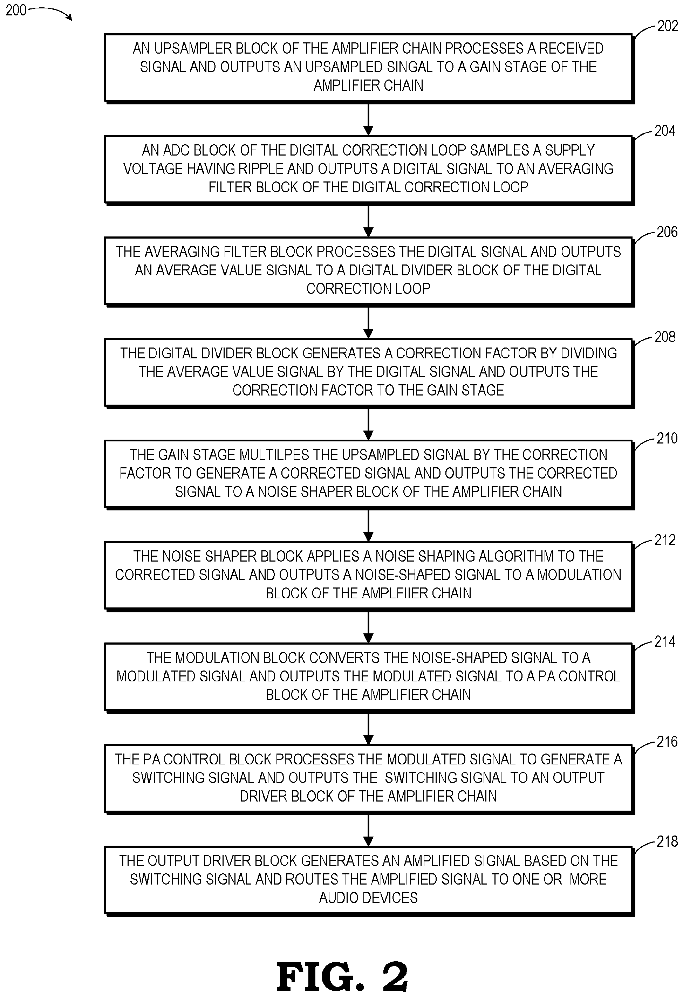

As such, FIG. 1 and FIG. 2 together describe a digital correction loop that compensates for fluctuations in supply voltage, improves PSR in Class D amplifiers and other switching amplifiers, and the like. The correction loop, of one or more implementations, samples the supply voltage with ripple and feeds the supply voltage back into the digital chain, allowing for precorrection adjustments to be made. This precorrection adjusts the gain in the digital chain, ultimately improving PSR. For example, the correction loop, in at least some implementations, includes an analog-to-digital converter (ADC), an averaging filter, and a digital divider. The ADC samples the supply voltage with ripple, and the averaging filter averages the ADC output to provide the average value of the supply. The digital divider divides the average value of the supply by the output of the ADC, which includes ripple on top of the average supply, to determine a correction factor. This correction factor is then multiplied with the up-sampler output to adjust the gain in the digital chain, thereby improving PSR. Improving the PSR of the amplifier ensures that power supply noise and ripple are effectively suppressed, which helps maintain a cleaner output signal and thereby indirectly reduces the perceived total harmonic distortion (THD), resulting in higher audio fidelity. Also, given that the digital correction loop is multiplicative, noise for small signals is not increased and the signal-to-noise and distortion (SINAD) for large signals is increased. It should be understood that although an audio signal is used herein as one example of a signal that is adjusted based on techniques described, the techniques described herein are applicable to various other types of signals, such as radio frequency (RF) signals, motor control signals, power supply signals, lighting control signals, and the like.

FIG. 1 is a schematic illustrating an example configuration of a Class D amplifier circuit 100 (also referred to herein as "amplifier 100") implementing a digital correction loop 104 to improve PSR in the amplifier 100 in accordance with at least some implementations. In the illustrated configuration, the amplifier 100 includes an amplifier chain 102 and a digital correction loop 104, and is coupled to one or audio output devices 106 (e.g., a speaker). It should be understood that the techniques described herein are also applicable to other Class D amplifier configurations as well.

In at least some implementations, the amplifier chain 102 includes an upsampler block 108 (also referred to herein as "upsampler 108"), a gain (amplifier) stage 110, a noise shaper block 112 (also referred to herein as "noise shaper 112"), a modulation block 114 (also referred to herein as "modulator 114"), a power amplifier (PA) control block 116 (also referred to herein as "power amplifier controller 116"), and an output driver block 118 (also referred to herein as "output driver 118"). The upsampler block 108, in at least implementations, receives an input signal 120 (e.g., a digital audio signal) from a digital signal processor (DSP) 142. The DSP 142 processes an incoming digital audio signal and performs tasks, such as filtering, equalization, and other digital audio enhancements. The DSP 142, in some implementations, is external to the amplifier 100, whereas, in other implementations, the DSP 142 is internal to or part of the amplifier 100. The processed signal 120 is then sent to an input node of the upsampler block 108 in the amplifier chain 102 via a signal path. The upsampler block 108 includes one or more circuits, such as digital filters (e.g., finite impulse response (FIR) filters, infinite impulse response (IIR) filters, a combination thereof, and the like), interpolation circuits, clock circuits, a combination thereof, and the like. The upsampler block 108 uses these components to increase the sample rate of the processed signal 120, which allows for finer resolution and better performance in subsequent stages. As such, the upsampler block 108 generates and outputs an upsampled signal 120-1 based on the processed signal 120 received from the DSP 142.

An output node of the upsampler block 108 is coupled to an input node of the gain stage 110. The gain stage 110 receives the upsampled signal 120-1 at its input node. The gain stage 110 includes digital signal processing elements that adjust the amplitude of the upsampled signal 120-1 to an appropriate level for further processing. For example, the gain stage 110 includes digital signal processors (DSPs), microcontrollers, or other digital processing units, along with digital-to-analog converters (DACs), to achieve the desired gain. As such, the gain stage 110 generates and outputs an amplified signal 120-2 based on the upsampled signal 120-1 received from the upsampler block 108.

The output node of the gain stage 110 is coupled to an input node of the noise shaper block 112. The noise shaper block 112 receives the amplified signal 120-2 at is input node. The noise shaper block 112 applies a noise shaping algorithm to the amplified signal 120-2, which redistributes quantization noise to less audible frequency bands, to generate a noise-shaped signal 120-3. For example, the noise shaper block 112 includes one or more circuits, such as digital filters (e.g., FIR, IIR, etc.), feedback loops, adders, subtractors, a combination thereof, and the like. The noise shaper block 112 uses these components to modifying the frequency characteristics of the quantization noise in the amplified signal 120-2. In at least some implementations, this is achieved using, for example, a delta-sigma ($\Delta\Sigma$) or other modulation approach. As such, the noise shaper block 112 generates and outputs a noise-shaped signal 120-3 based on the amplified signal 120-2 received from the gain stage 110.

An output node of the noise shaper block 112 is coupled to an input node of the modulation block 114. The modulation block 114 receives the noise-shaped signal 120-3 at its input node. The modulation block 114 converts the noise-shaped signal 120-3 into a pulse-width modulation (PWM) or pulse-density modulation (PDM) signal 120-4. For example, the modulation block 114 includes digital components, such as digital signal processors (DSPs), microcontrollers, and logic circuits, a combination thereof, and the like. The modulation block 114 uses these components to generate a PWM or PDM signal corresponding to the amplitude and frequency of the noise-shaped signal 120-3. As such, the modulation block 114 generates and outputs a modulated signal 120-4 based on the noise-shaped signal 120-3 received from the noise shaper block 112.

An output node of the modulation block 114 is coupled to, for example, one or more differential signal input nodes of the PA control block 116. The PA control block 116 receives the modulated signal 120-4 at its one or more differential signal input nodes. The PA control block 116 manages the power amplification process of the modulated signal 120-4 by, for example, managing the switching of power transistors to ensure that they operate efficiently and with minimal distortion. For example, the PA control block 116 includes one or more circuits, such as metal-oxide-semiconductor field-effect transistors (MOSFETs) drivers, logic gates, level shifters, control mechanisms, a combination therefore, and the like. The MOSFET drivers control the gates of MOSFETs, ensuring they switch on and off at the correct times. The logic gates are used to control the timing and logic of the switching process. The level shifters adjust signal levels to appropriate values for driving the MOSFETs. The control mechanisms are additional circuits, such as dead-time control, shoot-through protection, and feedback loops, to enhance performance and reliability. The PA control block 116 utilizes these components to, for example, ensure proper timing and control of the power transistors' switching, which includes managing the gain and ensuring minimal distortion, and convert the low-power PWM or PDM signal into a switching signal 120-5 suitable for driving the output block 118. As such, the PA control block 116 generates and outputs a switching signal 120-5 based on the modulated signal 120-4 received from the modulation block 114. The switching signal 120-5, in at least some implementations, is a differential output.

One or more output nodes of the PA control block 116 are coupled to one or more input nodes of the output driver block 118. In at least some implementations, the output of the PA control block 116 is also differential. The output driver block 118 receives the switching signal 120-5 at its one or more input nodes. The output driver block 118 interfaces with one or more power supply nodes, providing a positive supply voltage ($V_{SPDR}$) 122, and a negative supply voltage 124 ($V_{SS\_SDPR}$) or ground. This block 118 delivers the necessary current and voltage to drive the one or more audio output devices 106.

The output driver 118 amplifies the signal 120-5 from the PA control block 116 to a level sufficient to drive the audio output device(s) 106. Stated differently, the output driver 118 generates an amplified output signal. For example, the output driver block 118 includes one or more circuits, such as transistors, gate drivers, capacitors and inductors, a combination thereof, and the like. In at least some implementations, the transistors, such as high-speed MOSFETs, in an H-bridge configuration, which allows efficient bidirectional current flow through the load, providing the necessary power to the audio output device(s) 106 while minimizing power losses. In the example shown in FIG. 1, the configuration of the output driver block 118 includes four MOSFETs that switch the output voltage between the supply rails providing the supply voltages $V_{SPDR}$ 122 and $V_{SS\_SPDR}$ 124, amplifying the signal 120-5 from the PA control block 116 to the desired output level. The gate drivers are circuits to control the switching of the MOSFETs. The capacitors and inductors, if implemented, are used for filtering and smoothing the output signal. The amplified signal is then routed to the audio output device(s) 106 through one or more output nodes. These connections deliver the amplified audio signal to the audio output device(s) 106, producing the final audio output.

As described above, one of the inherent characteristics of Class D amplifiers, such as the amplifier 100, is their 0 dB PSR, which means that any ripple or noise on the power supply line providing the supply voltage $V_{SPDR}$ 122 is directly transferred to the output received by the audio output device, such as audio output device 106. The digital correct loop 104 overcomes this problem by sampling the power supply line having ripple to produce a correction factor that is fed back to the amplifier chain 102 for performing precorrection on the signal 120. This precorrection adjusts the gain in the amplifier chain 102, which improves the PSR.

In at least some implementations, the digital correct loop 104 includes an ADC block 126 (also referred to herein as "ADC 126"), an averaging filter block 128 (also referred to herein as "averaging filter 128"), and a digital divider block 130 (also referred to herein as "division divider 130"). The ADC block 126, in at least some implementations is a low power 10 bit successive approximation register (SAR) ADC. However, other types of ADCs and other resolutions are applicable as well. An input node of the ADC block 126 is connected to the supply voltage $V_{SPDR}$ 122. In at least some implementations, the bandwidth at the supply voltage $V_{SPDR}$ 122 node is determined by an external capacitor 132. Another input node of the ADC block 126 is connected to a clock source 140, $f_{CLCK}$. The ADC block 126, in at least some implementations, includes one or more circuits, such as an anti-aliasing filter and hold circuits, an analog multiplexer, a comparator, a successive approximation register (SAR), a digital-to-analog (DAC) converter, a clock generator, a reference voltage generator, error correction logic, a combination thereof, and the like. The ADC block 126 monitors and samples the supply voltage $V_{SPDR}$ 122 having ripple and outputs a digital signal ($V_{SUP\_RIP}$) 134 representing the supply voltage $V_{SPDR}$ 122 signal having ripple or noise.

An output node of the ADC block 126 is coupled to an input node of the averaging filter block 128. The averaging filter block 128 receives the digital signal 134 at its input node. The averaging filter block 128 processes the digital signal 134 by calculating the average of consecutive samples, thereby smoothing out variations and reducing noise in the digital signal 134. For example, the averaging filter block 128 includes one or more circuits, such as a shift register, an adder circuit, a divider circuit, control logic, a combination thereof, and the like. The averaging filter block 128 uses these components to calculate the average of a series of consecutive digital samples of the digital signal 134. Therefore, the output of the averaging filter block 128 is an average value signal

($V_{SUP\_AVG}$) 136 of the supply voltage $V_{SPDR}$ 122. In at least some implementations, the averaging filter block 128 is a moving averaging filter configured to compensate for the input voltage slowly dropping over time.

An output node of the averaging filter block 128 is coupled to an input node of the digital divider block 130. The digital divider block 130 receives the average value signal 136 at its input node and also receives the digital signal 134 from the ADC block 126 at another input node. The digital divider block 130 processes the digital signal 134 and the average value signal 136 to output a correction factor ($G_{out}$) 138 that compensates for the ripple or noise in the supply voltage $V_{SPDR}$ 122. For example, the digital divider block 130 includes one or more circuits, such as a number register, a denominator register, a subtractor, a shift register, control logic, a remainder register, a quotient register, a combination thereof, and the like. The digital divider block 130 uses these components to divide the average value signal 136 by the digital signal 134 to obtain the correction factor 138 according to:

$$G_{OUT} = \frac{V_{\text{SUP\_AVG}}}{V_{\text{SUP\_RIP}}} \quad (\text{EQ. 1}).$$

The output of the digital divider block 130 is coupled to an input of the gain stage 110 in the amplifier chain 102. The gain stage 110 receives the correction factor 138 at its input nodes and multiplies the signal 120-1 from upsampler block 108 by the correction factor 138. Stated differently, the gain stage 110 adjusts the gain of the signal 120-1 received from the upsampler block 108 according to the correction factor 138 , which compensates for the ripple in the supply voltage $V_{SPDR}$ 122 and improves the PSR. Therefore, the signal 120-2 output by the gain stage 110 is a corrected signal, and each subsequent block in the amplifier chain 102 (e.g., the noise shaper block 112, the modulator block 114, the PA control block 116, and the output driver block 116) operates on this corrected (input) signal. As such, the amplified signal generated by the output driver block 118 and received by the audio output device(s) 106 has been corrected or adjusted for any ripple or noise caused in the supply voltage $V_{SPDR}$ 122.

FIG. 2 is a diagram illustrating an example method 200 of compensating for ripple on a power supply line coupled to an amplifier 100 in accordance with at least some implementations. It should be understood that the processes described below with respect to method 200 have been described above in greater detail with reference to FIG. 1. The method 200 is not limited to the sequence of operations shown in FIG. 2, as at least some of the operations can be performed in parallel or in a different sequence. Moreover, in at least some implementations, the method 2 can include one or more different operations than those shown in FIG. 2.

At block 202, an upsampler block 108 of an amplifier chain 102 at the amplifier 100 process a received signal 120 (e.g., a digital audio signal or other type of signal) to generate an upsampled signal 120-1, and outputs the upsampled signal 120-1 to a gain stage 110 of the amplifier chain 102. At block 204, an ADC block 126 of a digital correct loop 104 at the amplifier 100 samples a supply voltage 122 having ripple or noise, and outputs a digital signal 134 representing the supply voltage 122 to an averaging filter block 128 of the digital correct loop 104. At block 206, the averaging filter block 128 processes the digital signal 134 by calculating the average of consecutive samples, and outputs an average value signal 136 of the supply voltage 122 to a digital divider block 130 of the digital correct loop 104. At block 208, the digital divider block 130 generates a correction factor 138 by dividing the average value signal 136 by the digital signal 134 received from the ADC block 126, and outputs the correction factor 138 to the gain stage 110 of the amplifier chain 102.

At block 210, the gain stage 110 multiples the upsampled signal 120-1 from the upsampler block 108 by the correction factor 138, which increases the gain of the upsampled signal 120-1, to generate a corrected signal 120-2, and outputs the corrected signal 120-2 to a noise shaper block 112 of the amplifier chain 102. At block 212, the noise shaper block 112 applies a noise shaping algorithm to the corrected signal 120-2 to generate a noise-shaped signal 120-3, and outputs the noise-shaped signal 120-3 to a modulation block 114 of the amplifier chain 102. At block 214, the modulation block 114 converts the noise-shaped signal 120-3 to a modulated signal 120-4, and outputs the modulated signal 120-4 to a PA control block 116 of the amplifier chain 102. At block 216, the PA control block 116 processes the modulated signal 120-4 to generate a switching signal 120-5 for driving the output driver 118, which drives one or more audio output devices 106. At block 218, output driver block 118 converts the switching signal 120-5 into the appropriate voltage and current levels needed to drive the audio output device(s) 106, and amplifies and routes the final amplified signal to the audio output device(s) 106.

An amplifier includes an amplifier chain and a digital correction loop coupled to the amplifier chain. The digital correction loop includes an analog-to-digital (ADC) converter, an averaging filter, and a digital divider. The digital correction loop is configured to generate a correction factor based on ripple or noise in a supply voltage. The amplifier chain is configured to apply the correction factor to an input signal.

Note that not all of the activities or elements described above in the general description are required, that a portion of a specific activity or device may not be required, and that one or more further activities may be performed or elements included in addition to those described. Still further, the order in which activities are listed are not necessarily the order in which they are performed. Also, the concepts have been described with reference to specific implementations. However, one of ordinary skill in the art appreciates that various modifications and changes can be made without departing from the scope of the present disclosure as set forth in the claims below. Accordingly, the specification and figures are to be regarded in an illustrative rather than a restrictive sense, and all such modifications are intended to be included within the scope of the present disclosure.

One or more of the elements described above is circuitry designed and configured to perform the corresponding operations described above. Such circuitry, in at least some implementations, is any one of, or a combination of, a hardcoded circuit (e.g., a corresponding portion of an application-specific integrated circuit (ASIC) or a set of logic gates, storage elements, and other components selected and arranged to execute the ascribed operations), a programmable circuit (e.g., a corresponding portion of a field programmable gate array (FPGA) or programmable logic device (PLD)), or one or more processors executing software instructions that cause the one or more processors to implement the ascribed actions. In some implementations, the circuitry for a particular element is selected, arranged, and configured by one or more computer-implemented design tools. For example, in some implementations the sequence of operations for a particular element is defined in a specified computer language, such as a register transfer language, and a computer-implemented design tool selects, configures, and arranges the circuitry based on the defined sequence of operations.

Within this disclosure, in some cases, different entities (which are variously referred to as "components", "units", "devices", "circuitry", etc.) are described or claimed as "configured" to perform one or more tasks or operations. This formulation of [entity] configured to [perform one or more tasks] is used herein to refer to structure (i.e., something physical, such as electronic circuitry). More specifically, this formulation is used to indicate that this physical structure is arranged to perform the one or more tasks during operation. A structure can be said to be "configured to" perform some task even if the structure is not currently being operated or used (e.g., a power supply is not connected to it). Thus, an entity described or recited as "configured to" perform some task refers to something physical, such as a device, circuitry, etc. This phrase is not used herein to refer to something intangible. Further, the term "configured to" is not intended to mean "configurable to". An unprogrammed field programmable gate array, for example, would not be considered to be "configured to" perform some specific function, although it could be "configurable to" perform that function after programming. Additionally, reciting in the appended claims that a structure is "configured to" perform one or more tasks is expressly intended not to be interpreted as having means-plus-function elements.

Benefits, other advantages, and solutions to problems have been described above with regard to specific implementations. However, the benefits, advantages, solutions to problems, and any feature(s) that may cause any benefit, advantage, or solution to occur or become more pronounced are not to be construed as a critical, required, or essential feature of any or all the claims. Moreover, the particular implementations disclosed above are illustrative only, as the disclosed subject matter may be modified and practiced in different but equivalent manners apparent to those skilled in the art having the benefit of the teachings herein. No limitations are intended to the details of construction or design herein shown, other than as described in the claims below. It is therefore evident that the particular implementations disclosed above may be altered or modified and all such variations are considered within the scope of the disclosed subject matter. Accordingly, the protection sought herein is as set forth in the claims below.

**Claims**

1. An amplifier, comprising:

   an amplifier chain; and
   a digital correction loop configured to compensate for fluctuations in a supply voltage, the digital correction loop comprising:

      an analog-to-digital (ADC) converter;
      an averaging filter; and
      a digital divider.

2. The amplifier of claim 1, wherein an output of the ADC is coupled to an input of the averaging filter and an output of the averaging filter is coupled to an input of the digital divider.

3. The amplifier of any preceding claim, wherein an output of the amplifier chain is coupled to an input of one or more audio output devices.

4. The amplifier of any preceding claim, wherein the amplifier chain includes an upsampler, a gain stage, a noise shaper, a modulator, a power amplifier controller, and an output driver.

5. The amplifier of claim 4, wherein:

   an output of the upsampler is coupled to an input of the gain stage;
   an output of the gain stage is coupled to an input of the noise shaper;
   an output of the noise shaper is coupled to an input of the modulator;
   an output of the modulator is coupled to an input of the power amplifier controller; and
   an output of the power amplifier controller is coupled to an input of the output driver.

6. The amplifier of claim 5, wherein an output of the output driver is coupled to an input of one or more audio output devices.

7. The amplifier of any preceding claim, wherein ADC is configured to:

sample a supply voltage; and
generate a digital signal representing the supply voltage.

8. The amplifier of any preceding claim, wherein the averaging filter is configured to:

calculate an average of a series of consecutive digital samples of a digital signal representing a supply voltage; and
generate an average value signal of the supply voltage based on the calculated average.

9. The amplifier of any preceding claim , wherein the digital divider is configured to:

divide an average value signal of a supply voltage by a digital signal representing the supply voltage;
generate a correction factor for ripple or noise on the supply voltage based on the average value signal being divided by the digital signal; and
output the correction factor to the amplifier chain.

10. The amplifier of claim 9, wherein the amplifier chain is configured to:

apply the correction factor to a signal to generate a corrected signal; and
output the corrected signal to a component coupled to the amplifier.

11. The amplifier of claim 10, wherein the amplifier chain comprises a gain stage and wherein the amplifier chain is configured to apply the correction factor by:

receiving, by the gain stage, the correction factor from the digital divider;
increasing, by the gain stage, a gain of the signal based on the correction factor to generate the corrected signal; and
outputting the corrected signal to a subsequent component of the amplifier chain.

12. A method at an amplifier, comprising:

monitoring, by a digital correction loop, a supply voltage;
generating, by the digital correction loop, a correction factor based on the supply voltage;
applying, by an amplifier chain, the correction factor to an input signal to generate a corrected input signal; and
outputting the corrected input signal to a component coupled to the amplifier.

13. The method of claim 12, wherein generating the correction factor comprises:

sampling, by the digital correction loop, the supply voltage; and
generating, by the digital correction loop, a digital signal representing the supply voltage.

14. The method of claim 12 or 13, wherein generating the correction factor comprises:

calculating an average of a series of consecutive digital samples of a digital signal representing the supply voltage; and
generating an average value signal of the supply voltage based on the calculated average.

15. The method of any of claims 12 to 14, wherein generating the correction factor comprises:

dividing an average value signal of a supply voltage by a digital signal representing the supply voltage;
generating a correction factor for ripple or noise on the supply voltage based on the average value signal being divided by the digital signal; and
outputting the correction factor to the amplifier chain.

FIG. 1

200 ⟍

202

AN UPSAMPLER BLOCK OF THE AMPLIFIER CHAIN PROCESSES A RECEIVED SIGNAL AND OUTPUTS AN UPSAMPLED SINGAL TO A GAIN STAGE OF THE AMPLIFIER CHAIN

204

AN ADC BLOCK OF THE DIGITAL CORRECTION LOOP SAMPLES A SUPPLY VOLTAGE HAVING RIPPLE AND OUTPUTS A DIGITAL SIGNAL TO AN AVERAGING FILTER BLOCK OF THE DIGITAL CORRECTION LOOP

206

THE AVERAGING FILTER BLOCK PROCESSES THE DIGITAL SIGNAL AND OUTPUTS AN AVERAGE VALUE SIGNAL TO A DIGITAL DIVIDER BLOCK OF THE DIGITAL CORRECTION LOOP

208

THE DIGITAL DIVIDER BLOCK GENERATES A CORRECTION FACTOR BY DIVIDING THE AVERAGE VALUE SIGNAL BY THE DIGITAL SIGNAL AND OUTPUTS THE CORRECTION FACTOR TO THE GAIN STAGE

210

THE GAIN STAGE MULTILPES THE UPSAMPLED SIGNAL BY THE CORRECTION FACTOR TO GENERATE A CORRECTED SIGNAL AND OUTPUTS THE CORRECTED SIGNAL TO A NOISE SHAPER BLOCK OF THE AMPLIFIER CHAIN

212

THE NOISE SHAPER BLOCK APPLIES A NOISE SHAPING ALGORITHM TO THE CORRECTED SIGNAL AND OUTPUTS A NOISE-SHAPED SIGNAL TO A MODULATION BLOCK OF THE AMPLFIIER CHAIN

214

THE MODULATION BLOCK CONVERTS THE NOISE-SHAPED SIGNAL TO A MODULATED SIGNAL AND OUTPUTS THE MODULATED SIGNAL TO A PA CONTROL BLOCK OF THE AMPLIFIER CHAIN

216

THE PA CONTROL BLOCK PROCESSES THE MODULATED SIGNAL TO GENERATE A SWITCHING SIGNAL AND OUTPUTS THE SWITCHING SIGNAL TO AN OUTPUT DRIVER BLOCK OF THE AMPLIFIER CHAIN

218

THE OUTPUT DRIVER BLOCK GENERATES AN AMPLIFIED SIGNAL BASED ON THE SWITCHING SIGNAL AND ROUTES THE AMPLIFIED SIGNAL TO ONE OR MORE AUDIO DEVICES

# FIG. 2

Europäisches
Patentamt

European
Patent Office

Office européen
des brevets

# EUROPEAN SEARCH REPORT

**Application Number**

EP 25 19 4024

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 103 856 170 B (UNIV NORTHWESTERN POLYTECHNIC) 1 February 2017 (2017-02-01) | 1,12 | INV. H03F1/30 |
| A | * paragraphs [0026] - [0031]; figures 2,3 * | 2-11, 13-15 | H03F3/183 H03F3/217 |
| | ----- | | |
| X | JP 3 801118 B2 (MITSUBISHI ELECTRIC CORP) 26 July 2006 (2006-07-26) * paragraphs [0050] - [0057]; figures 8,9 * | 1-15 | |
| | ----- | | |
| A | EP 2 312 747 A2 (HARMAN INT IND [US]) 20 April 2011 (2011-04-20) * paragraphs [0018], [0038]; figures 1,4 * | 1-15 | |
| | ----- | | |
| A | US 2004/228416 A1 (ANDERSON JACK [US] ET AL) 18 November 2004 (2004-11-18) * paragraphs [0026] - [0035]; figures 1,2a,2b,3a,3b * | 1-15 | |
| | ----- | | TECHNICAL FIELDS SEARCHED (IPC) |
| A | US 2007/194845 A1 (KOST MICHAEL A [US] ET AL) 23 August 2007 (2007-08-23) * paragraphs [0025] - [0030], [0033] - [0035]; figures 1,4,5 * | 1-15 | H03F |
| | ----- | | |

The present search report has been drawn up for all claims

| Place of search | Date of completion of the search | Examiner |
|---|---|---|
| The Hague | 12 December 2025 | Zakharian, Andre |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 19 4024

This annex lists the patent family members relating to the patent documents cited in the above-mentioned European search report.
The members are as contained in the European Patent Office EDP file on
The European Patent Office is in no way liable for these particulars which are merely given for the purpose of information.

12-12-2025

| Patent document cited in search report | | Publication date | Patent family member(s) | | Publication date |
|---|---|---|---|---|---|
| CN 103856170 | B | 01-02-2017 | NONE | | |
| JP 3801118 | B2 | 26-07-2006 | JP | 3801118 B2 | 26-07-2006 |
| | | | JP | 2004088431 A | 18-03-2004 |
| EP 2312747 | A2 | 20-04-2011 | EP | 1798852 A2 | 20-06-2007 |
| | | | EP | 2312747 A2 | 20-04-2011 |
| | | | US | 2007140513 A1 | 21-06-2007 |
| | | | US | 2012008796 A1 | 12-01-2012 |
| US 2004228416 | A1 | 18-11-2004 | AT | E332588 T1 | 15-07-2006 |
| | | | AU | 2003296449 A1 | 29-07-2004 |
| | | | DE | 60306685 T2 | 28-06-2007 |
| | | | DK | 1579570 T3 | 30-10-2006 |
| | | | EP | 1579570 A2 | 28-09-2005 |
| | | | JP | 4157098 B2 | 24-09-2008 |
| | | | JP | 2006512851 A | 13-04-2006 |
| | | | US | 6741123 B1 | 25-05-2004 |
| | | | US | 2004228416 A1 | 18-11-2004 |
| | | | WO | 2004062089 A2 | 22-07-2004 |
| US 2007194845 | A1 | 23-08-2007 | NONE | | |

EPO FORM P0459

For more details about this annex : see Official Journal of the European Patent Office, No. 12/82